# EUROPEAN PATENT SPECIFICATION

(11) **EP 0 686 480 B1**
(45) Date of publication and mention of the grant of the patent: **28.11.2001**
(21) Application number: 95111925.4
(22) Date of filing: 17.04.1989
(51) Int. Cl.: B29C 67/00

(54) **Stereolithographic supports**
Stereolithografische Stützen
Supports stéréolithographiques

(30) Priority: 18.04.1988 US 182801; 08.11.1988 US 269801
(43) Date of publication of application: 13.12.1995
(62) Divisional of application: 89303786.1
(73) Proprietor: 3D SYSTEMS, INC., Valencia, California 91355 (US)
(72) Inventor: Hull, Charles W., Santa Clarita, CA 91350 (US); Lewis, Charles W., Sherman Oaks, CA 91403 (US)
(74) Representative: Hess, Peter K., Dipl.-Phys.

(56) References cited:
- EP-A- 0 250 121
- WO-A-90/11178
- US-A- 4 575 330
- PATENT ABSTRACTS OF JAPAN vol. 010, no. 118 (M-475), 2 May 1986 & JP-A-60 247515 (OOSAKAFU), 7 December 1985,

## Description

### Background of the Invention

### 1. Cross Reference to Related Prior Art Applications

As to the prior art it is referred to U.S. Patent Application Serial Nos. 182,823; 182,830; 183,015; 182,801; 183,016; 183,014; and 183,012; filed April 18, 1988, Continuations-in-part of U.S. Patent Application Serial Nos. 182,830; 183,016; 183,014; and 183,012 were filed on November 8, 1988, the Serial Nos. for the above-mentioned continuations-in-part are, respectively, 269,801; 268,816; 268,337; 268,907 (all for Ser. No. 182,830); 268,429 (for Ser. No. 183,016); 268,408 (for Ser. No. 183,014); and 263,428 (for Ser. No. 183,012). A continuation application of U.S. Patent Application S.N. 269,801 was filed on March 31, 1989. The Lyon & Lyon Docket No. for the above-mentioned continuation application is 186/195.

### 2. Cross Reference to Attached Appendix

The following appendix is affixed and is hereby fully incorporated into this disclosure as though set forth in full herein:
- Appendix D:: 3D Systems, Inc., SLA-1 Training Manual, Revision 3.0, April, 1988 Orient & Support, Section 3.2, original page 3.2-1 through 3.2-7.

### 3. Field of the Invention

This invention relates to a stereolithographic method of and a stereolithographic apparatus for forming a three-dimensional object according to the precharacterising part of claims 1, 2, 16 and 17 respectively. Stereolithography system involve the application of enhanced data manipulation and lithographic techniques to production of three-dimensional objects and stereolithographic supports for the object whereby such objects can be formed more rapidly, reliably, accurately and economically.

### 4. Background of the Invention

It is common practice in the production of plastic parts and the like to first design such a part and then painstakingly produce a prototype of the part, all involving considerable time, effort and expense. The design is then reviewed and, oftentimes, the laborious process is again and again repeated until the design has been optimized. After design optimization, the next step is production. Most production plastic parts are injection molded. Since the design time and tooling costs are very high, plastic parts are usually only practical in high volume production. While other processes are available for the production of plastic parts, including direct machine work, vacuum-forming and direct forming, such methods are typically only cost effective for short run production, and the parts produced are usually inferior in quality to molded parts.

very sophisticated techniques have been developed in the past for generating three-dimensional objects within a fluid medium which is selectively cured by beams of radiation brought to selective focus at prescribed intersection points within the three-dimensional volume of the fluid medium. Typical of such three-dimensional systems are those described in U.S. Pat. Nos. 4,041,476; 4,078,229; 4,238,840 and 4,288,861. All of these systems rely upon the buildup of synergistic energization at selected points deep within the fluid volume, to the exclusion of all other points in the fluid volume. Unfortunately, however, such three-dimensional forming systems face a number of problems with regard to resolution and exposure control. The loss of radiation intensity and image forming resolution of the focused spots as the intersections move deeper into the fluid medium create rather obvious complex control situations. Absorption, diffusion, dispersion and diffraction all contribute to the difficulties of working deep within the fluid medium on an economical and reliable basis.

In recent years, "stereolithography" systems, such as those described in U.S. Pat. No. 4,575,330 entitled "Apparatus For Production Of Three-Dimensional Objects By Stereolithography," which is hereby fully incorporated by reference into this disclosure as though set forth in full herein, have come into use. Basically, stereolithography is a method for automatically building complex plastic parts by successively printing cross-sections of photopolymer (such as liquid plastic) on top of each other until all of the thin layers are joined together to form a whole part. With this technology, the parts are literally grown in a vat of liquid plastic. This method of fabrication is extremely powerful for quickly reducing design ideas to physical form and for making prototypes.

Photocurable polymers change from liquid to solid in the presence of light and their photospeed with ultraviolet light is fast enough to make them practical model building materials. The material that is not polymerized when a part is made is still usable and remains in the vat as successive parts are made. An ultraviolet laser generates a small intense spot of UV. This spot is moved across the liquid surface with a galvanometer mirror X-Y scanner. The scanner is driven by computer generated vectors or the like. Precise complex patterns can be rapidly produced with this technique.

The laser scanner, the photopolymer vat and the elevator, along with a controlling computer, combine together to form a stereolithography apparatus, referred to as an "SLA". An SLA is programmed to automatically make a plastic part by drawing a cross section at a time, and building it up layer by layer.

Stereolithography represents an unprecedented way to quickly make complex or simple parts without tooling. Since this technology depends on using a computer to generate its cross sectional patterns, there is a natural data link to CAD/CAM. However, such systems have encountered difficulties relating to shrinkage, curl and other distortions, as well as resolution, accuracy and difficulties in producing certain object shapes.

Supports are shown in the figures in Patent No. 4,575,330, and these supports attach the object to the platform.

The original type of posts/supports used were actually formed by curing single points. These points were cured for specific lengths of time to give appropriate cure depths, with a corresponding cure width. This type of post is limited by its strength, and the associated cure time required to achieve this strength level (if even possible to obtain the desired strength).

Another type of post/support structure is based on the need to increase the adhesion strength between layers. The adhesion strength is proportional to the area of contact between layers. When curing a point the cure width quickly reaches a limit where additional cure width is impractical; therefore, another method of increasing contact area was implemented. Instead of curing supports that are point vectors in cross-section this next phase uses supports that are polygons in cross-section. These polygons can be triangles, rectangles, octagons, etc. These structures give us much greater contact area between layers (much greater adhesion strength), along with much greater structural strength against horizontal translation. These supports worked reasonable well but they still encounter some difficulties in that: 1) they were hard to removed from the object, 2) they offered support to only a limited number of object vectors, and 3) this type of support structure required the use of a base to support the polygons to insure attachment of the perforated platform.

Furthermore, the prior art discloses different techniques and methods for forming 3-dimensional objects. In the journal "High Technology" of August 1983, an article titled "LASER SCULPT MOLDS FOR COMPLEX PARTS" describes a method of computer-aided manufacturing. A laser mold-making is used to build different objects. This method fits well into a so-called "shape feedback network". The method comprises the following steps: Design part on computer; use stored design to manipulate lasers, fabricate a test mold, cast the part, examine the part with sensors hooked up to the computer, make necessary design changes and repeat the steps until the parts meet the specification.

In the presentation of Charles Hull at the Dataquest CAD/CAM Industry Conference in Monterey on May 15, 1987 titled "INSTANT 3-D PLASTIC HARDCOPY & PROTOTYPING", a further development of a stereolithography method is described. Therein, the part to be built is designed using the solid model CAD system. The CAD system provides the stereolithography apparatus with computer data describing the object to be built. Based on these computer data, the object is formed from a photocurable polymer, wherein free standing sections of the object are supported by post-support structures. After completing the object by the stereolithography apparatus, the support structure is cut away and perhaps a painting or other surface finishing is applied to the object.

An article written by Thomas Eifler titled "INSTANT MODELS THROUGH STEREOLITHOGRAPHY" published in Laser Review, January 1988, describes main manufacturing steps in the process of forming 3-dimensional objects by stereolithography. It is pointed out that the stereolithography apparatus uses a computer-generated design to program the model-making process. This system, which is compatible with existing (CAD) systems, creates different objects in various materials, as well as in a variety of colors, hardnesses, and abrasional resistances. Therefore, the stereolithography system can be used in different fields of industry as for example in automotive industry.

A further prior art approach is given by the article titled "FABRICATION OF 3-DIMENSIONAL OBJECTS USING LASER LITHOGRAPHY" by Nakai and Marutani, published in Denshi Joho Tsushin Gakikai Ronbunshi, Vol. 71-D, No. 2, February 1988, pp. 416-423, "FABRICATION OF THREE-DIMENSIONAL OBJECTS USING LASER LITHOGRAPHY". According to the technique described in the article, the CAD data designed by a computer are sliced horizontally. Using the sliced data, the laser is moved in a 2-D-direction and the light-sensitive resin is irradiated. Then solidified thin plates are stacked to form a pattern.

The EP 0 250 121 represents the closest prior art. A stereolithographic technique is disclosed which comprises an apparatus for providing coordinate information with respect to the 3-dimensional object such as a 3-dimensional digitizer, a workstation arranged to receive the coordinate information from the coordinate-providing apparatus, and to permit manipulation of the coordinate information. A 3-dimensional object is provided by a further apparatus responsive to the manipulated coordinated information. The data to form an object are provided in the form of voxels which are grouped into 2-dimensional layers which do not require slicing. It is a great disadvantage, that the low-level format is not adapted to take complex shapes of an object to be supported into consideration.

Therefore, it is the object of the present invention to provide a stereolithographic method as well as a stereolithographic apparatus which have an increased flexibility regarding the design construction of support structures.

This object is solved by a stereolithographic method in accordance with claims 1 and 2, and a stereolithographic apparatus in accordance with claims 16 and 17.

Particular embodiments of the invention are the subject of the dependent claims.

The present invention as defined in claims 1, 2, 16 and 17 meets a long existing need in the design and production arts for the capability of rapidly and reliably moving from the design stage to the prototype stage and to ultimate production, particularly moving directly from the computer design stage for plastic parts to virtually immediate prototypes and the facility for large scale production on an economical and automatic basis.

Accordingly, those concerned with the development and production of three-dimensional plastic objects and the like have long recognized the desirability for further improvement in more rapid, reliable, economical and automatic means which would facilitate quickly moving from a design stage to the prototype stage and to production, while avoiding the support problems of the previous three-dimensional production systems. The present invention clearly fulfills all of these needs.

Basically, the present invention provides a new and improved stereolithography system for generating a three-dimensional object by forming successive, adjacent, cross-sectional laminae of that object at the face of a fluid medium capable of altering its physical state in response to appropriate synergistic stimulation, information defining the object being specially processed to provide necessary object supports, the successive laminae being automatically integrated as they are formed to define the desired three-dimensional object.

In a presently preferred embodiment, by way of example and not necessarily by way of limitation, the present invention harnesses the principles of computer generated graphics in combination with stereolithography. i.e., the application of lithographic techniques to the production of three-dimensional objects, to simultaneously execute computer aided design (CAD) and computer aided manufacturing (CAM) in producing three-dimensional objects directly from computer instructions. The invention can be applied for the purposes of sculpturing models and prototypes in a design phase of product development, or as a manufacturing system, or even as a pure art form.

Briefly and in general terms, the present invention provides an object support system which solves several problems. It supplies a method of attaching an object to the platform. It allows easy removal of a cured part from the platform. It allows better control of the thickness of the first layer of the part. It improves liquid flow in and around the part. It decreases required dip time. It allows the part to drain faster and better. It anchors free floating boundaries (i.e., insures borders are held in place until cross-hatch is drawn). It prevents deformation due to curl, due to forces associated with dipping, and due to the weight of the part. It anchors part sections that otherwise would not attach to anything (until future layers are drawn).

"Stereolithography" is a method and apparatus for making solid objects by successively "printing" thin layers of a curable material, e.g., a curable material, one on top of the other. A programmed movable spot beam of UV light shining on a surface or layer of curable liquid is used to form a solid cross-section of the object at the surface of the liquid. The object is then moved, in a programmed manner, away from the liquid surface by the thickness of one layer, and the next cross-section is then formed and adhered to the immediately preceding layer defining the object. This process is continued until the entire object is formed.

Essentially all types of object forms can be created with the technique of the present invention. Complex forms are more easily created by using the functions of a computer to help generate the programmed commands and to then send the program signals to the stereolithographic object forming subsystem.

Of course, it will be appreciated that other forms of appropriate synergistic stimulation for a curable fluid medium, such as particle bombardment (electron beams and the like), chemical reactions by spraying materials through a mask or by ink jets, or impinging radiation other than ultraviolet light, may be used in the practice of the invention without departing from the spirit and scope of the invention.

By way of example, in the practice of the present invention, a body of a fluid medium capable of solidification in response to prescribed stimulation is first appropriately contained in any suitable vessel to define a designated working surface of the fluid medium at which successive cross-sectional laninae can be generated. Thereafter, an appropriate form of synergistic stimulation, such as a spot of UV light or the like, is applied as a graphic pattern at the specified working surface of the fluid medium to form thin, solid, individual layers at the surface, each layer representing an adjacent cross-section of the three-dimensional object to be produced. In accordance with the invention, information defining the object is specially processed to reduce curl and distortion, and increase resolution, strength, accuracy, speed and economy of reproduction.

Superposition of successive adjacent layers on each other is automatically accomplished, as they are formed, to integrate the layers and define the desired three-dimensional object. In this regard, as the fluid medium cures and solid material forms as a thin lamina at the working surface, a suitable platform to which the first lamina is secured is moved away from the working surface in a programmed manner by any appropriate actuator, typically all under the control of a micro-computer of the like. In this way, the solid material that was initially formed at the working surface is moved away from that surface and new liquid flows into the working surface position. A portion of this new liquid is, in turn, converted to solid material by the programmed light spot to define a new lamina, and this new lamina adhesively connects to the material adjacent to it, i.e., the immediately preceding lamina. This process continues until the entire three-dimensional object has been formed. The formed object is then removed from the container and the apparatus is ready to produce another object, either identical to the first object or an entirely new object generated by a computer or the like.

The database of a CAD system can take several forms. One form consists of representing the surface of an object as a mesh of polygons, typically triangles. These triangles completely form the inner and outer surfaces of the object. This CAD representation also includes a unit length normal vector for each triangle. The normal points away from the solid which the triangle is bounding and indicates slope. Means are provided for processing the CAD data, which may be in the form of "PHIGS" or the like, into layer-by-layer vector data that can be used for forming models through stereolithography. Such information may ultimately be converted to raster scan output data or the like.

As previously indicated, stereolithography is a three-dimensional printing process which uses a moving laser beam to build parts by solidifying successive layers of liquid plastic. This method enables a designer to create a design on a CAD system, applying the concepts of the invention to reduce curl, stress, and to provide suitable supports and build an accurate plastic model in a few hours. By way of example, a stereolithographic process may include the following steps.

First, the solid model is designed in the normal way on the CAD system, without specific reference to the stereolithographic process.

Model preparation for stereolithography involves selecting the optimum orientation, adding supports, building in appropriate stress relief, and selecting the operating parameters of the stereolithography system. The optimum orientation will (1) enable the object to drain, (2) have the least number of unsupported surfaces, (3) optimize important surfaces, and (4) enable the object to fit in the resin vat. Supports must be added to secure unattached sections and for other purposes, and a CAD library of supports can be prepared for this purpose. The stereolithography operating parameters include selection of the model scale and layer ("SLICE") thickness.

The surface of the solid model is then divided into triangles, typically "PHIGS". A triangle is the least complex polygon for vector calculations. The more triangles formed, the better the surface resolution and hence, the more accurate the formed object with respect to the CAD design.

Data points representing the triangle coordinates and normals thereto are then transmitted typically as PHIGS, to the stereolithographic system via appropriate network communication such as ETHERNET. The software of the stereolithographic system then slices the triangular sections horizontally (X-Y plane) at the selected layer thickness.

The stereolithographic unit (SLA) next calculates the section boundary, hatch, and horizontal surface (skin) vectors. Hatch vectors consist of cross-hatching between the boundary vectors. Several "styles" or slicing formats are available. Skin vectors, which are traced at high speed and with a large overlap, form the outside horizontal surfaces of the object. Interior horizontal areas, those within top and bottom skins, are not filled in other than by cross-hatch vectors. More details about vectors are provided in S.N. 182,830, its CIP, S.N. 269,801, and its continuation, Lyon & Lyon Docket No. 186/195.

The SLA then forms the object one horizontal layer at a time by moving the ultraviolet beam of a helium-cadmium laser or the like across the surface of a photocurable resin and solidifying the liquid where it strikes. Absorption in the resin prevents the laser light from penetrating deeply and allows a thin layer to be formed. Each layer is comprised of vectors which are typically drawn in the following order: border, hatch, and surface.

The first layer that is drawn by the SLA adheres to a horizontal platform located just below the liquid surface. This platform is attached to an elevator which then lowers the platform under computer control. After drawing a layer, the platform dips a short distance, such as several millimeters into the liquid to coat the previous cured layer with fresh liquid, then rises up a smaller distance leaving a thin film of liquid from which the second layer will be formed. After a pause to allow the liquid surface to flatten out, the next layer is drawn. Since the resin has adhesive properties, the second layer becomes firmly attached to the first. This process is repeated until all the layers have been drawn and the entire three-dimensional object is formed. Normally, the bottom 6,35·10⁻³ m (0.25 inch) or so of the object is a support structure on which the desired part is built. Resin that has not been exposed to light remains in the vat to be used for the next part. There is very little waste of material.

Post processing typically involves draining the formed object to remove excess resin, ultraviolet or heat curing to complete polymerization, and removing supports. Additional processing, including sanding and assembly into working models, may also be performed.

Supports are provided in the form of "Webs". Webs, in cross-section, are long, slender, rectangular structures. The width of a web is designed thin enough to be easy to remove from the part after post curing. The length of a web is designed to meet two requirements: 1) long enough to give good adhesion to the elevator platform (without need of a base), and 2) long enough to span the cross-section of the object (to give support to cross-hatch and the boundaries enclosing it).

All of these types of supports are used to attach objects to platforms (elevators), but they are also used to give critical areas of the object extra support. These critical areas may include upper edges of windows, cantilevers, etc. Webs may start at the elevator platform and work their way up to the section that requires support or they may actually start on one section of the part and work their way up to another section that needs support.

The stereolithographic apparatus has many advantages over currently used apparatus for producing plastic objects. The methods and apparatus of the present invention avoid the need of producing design layouts and drawings, and of producing tooling drawings and tooling. The designer can work directly with the computer and a stereolithographic device, and when he is satisfied with the design as displayed on the output screen of the computer, he can fabricate a part for direct examination. If the design has to be modified, it can be easily done through the computer, and then another part can be made to verify that the change was correct. If the design calls for several parts with interacting design parameters, the method of the invention becomes even more useful because all of the part designs can be quickly changed and made again so that the total assembly can be made and examined, repeatedly if necessary. Moreover, the data manipulation techniques of the present invention enable production of objects with reduced stress, curl and distortion, and increased resolution, strength, accuracy, speed and economy of production, even for difficult and complex object shapes.

After the design is complete, part production can begin immediately, so that the weeks and months between design and production are avoided. Stereolithography is particularly useful for short run production because the need for tooling is eliminated and production set-up time is minimal. Likewise, design changes and custom parts are easily provided using the technique. Because of the ease of making parts, stereolithography can allow plastic parts to be used in many places where metal or other material parts are now used. Moreover, it allows plastic models of objects to be quickly and economically provided, prior to the decision to make more expensive metal or other material parts.

Hence, the stereolithographic methods and apparatus of the present invention satisfy a long existing need for an improved CAD/CAM-interfaced system capable of rapidly, reliably, accurately and economically designing and fabricating three-dimensional parts and the like with reduced stress and curl and with adequate supports.

The above and other advantages of this invention will be apparent from the following more detailed description when taken in conjunction with the accompanying drawings of illustrative embodiments.

### Brief Description of the Drawings

FIG. 1 is a overall block diagram of a stereolithography system for the practice of the present invention;
FIGS. 2 and 3 are flow charts illustrating the basic concepts employed in practicing the method of stereolithography of the present invention;
FIG. 4 is a combined block diagram, schematic and elevational sectional view of a system suitable for practicing the invention;
FIG. 5 is an elevational sectional view of a second embodiment of a stereolithography system for the practice of the invention;
FIG. 6 is a software architecture flow chart depicting in greater detail the overall data flow, data manipulation and data management in a stereolithography system;
FIG. 7 illustrates how supports anchor layer borders in place until cross-hatch vectors are drawn;
FIG. 8 illustrates how supports prevent deformation and curl of cantilevered beams and similar structures;
FIG. 9 illustrates how supports attach layer sections that would otherwise be temporarily unattached while the part is being built;
FIG. 10 illustrates how perpendicular web supports prevent layer skewing; and
FIG. 11 illustrates use of diagonal supports.

### Description of the Preferred Embodiment

Stereolithography parts are preferably built on structures known as supports, rather than directly on the elevator platform. One reason for using supports is to separate the part from the platform. A part cured directly to the platform would be difficult to remove, especially if the adhering surface is large. Furthermore, the thickness of the first layer formed on the platform cannot be accurately controlled and may even vary if the platform is warped or improperly installed. This could result in lines which are not cured deeply enough to adhere to the platform, a condition that could promote curl. Even without these potential problems, the holes in the platform would create matching bumps on the bottom surface of any part made directly on it. Displacement of liquid as the platform is submerged can change the thickness of the first few layers, and these effects would be undesirable within the part itself.

Another reason for using supports is to improve liquid flow around the part. This enables use of a shorter dip time, since the surface of the liquid will settle faster with improved flow. Additionally, excess resin will drain faster from the completed part to reduce post processing time.

Supports are also used to anchor sections of a part which would otherwise have a tendency to move and to strengthen areas susceptible to curl or damage during dipping.

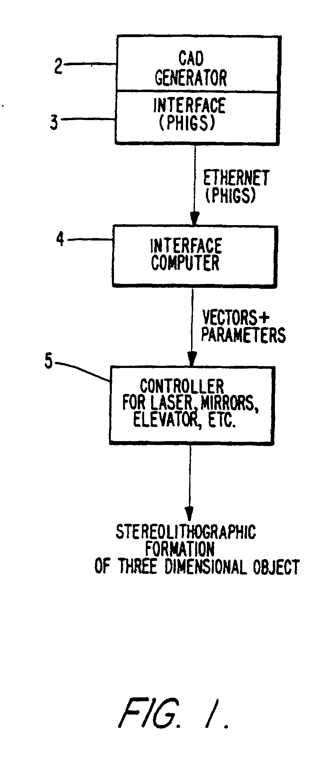

Referring now to the drawings, and particularly to FIG. 1 thereof, there is shown a block diagram of an overall stereolithography system suitable for practicing the present invention. A CAD generator 2 and appropriate interface 3 provide a data description of the object to be formed, typically in PHIGS format, via network communication such as ETHERNET or the like to an interface computer 4 where the object data is manipulated to optimize the data and provide output vectors which reduce stress, curl and distortion, and increase resolution, strength, accuracy, speed and economy of reproduction, even for rather difficult and complex object shapes. The interface computer 4 generates layer data by slicing, varying layer thickness, rounding polygon vertices, filling, generating flat skins, near-flat skins, up-facing and down-facing skins, scaling, cross-hatching, offsetting vectors and ordering of vectors. This is described in more detail in S.N. 182,830, its CIP, S.N. 269,801, and its continuation, Lyon & Lyon Dkt. No. 186/195. Briefly, boundary vestors are used to trace an outline for each cross section of an object, cross-hatch vectors are used to trace the internal portion of each cross section, and skin vectors are used to trace the outer surfaces of the object. These vectors are traced in the following order: boundary, cross-hatch, and skin.

The vector data and parameters from the computer 4 are directed to a controller subsystem 5 for operating the stereolithography system laser, mirrors, elevator and the like.

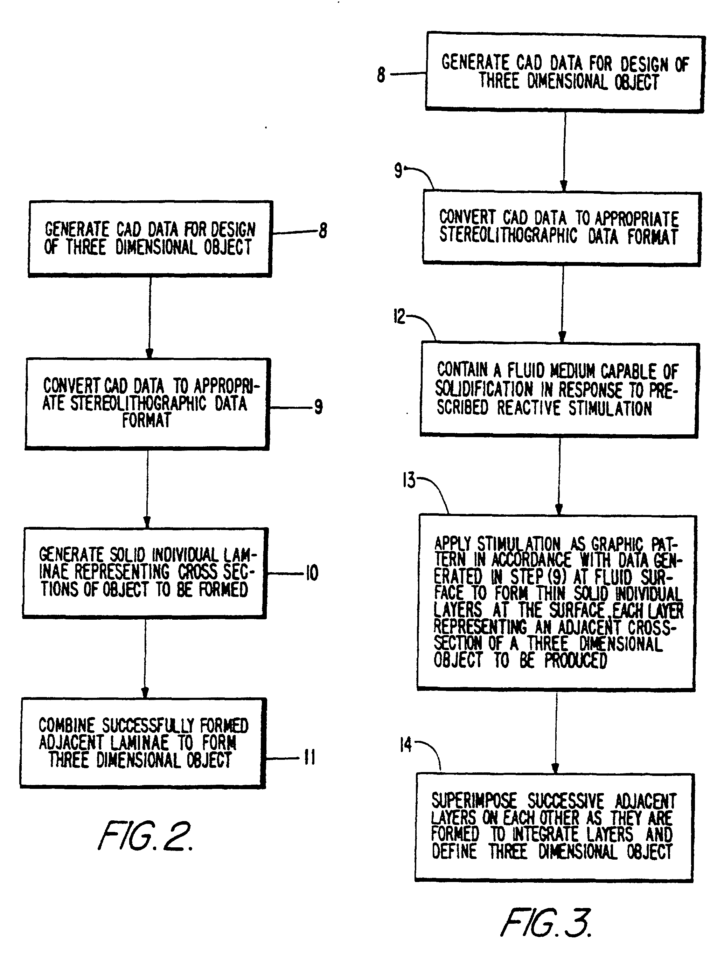

FIGS. 2 and 3 are flow charts illustrating the basic system of the present invention for generating three-dimensional objects by means of stereolithography.

Many liquid state chemicals are known which can be induced to change to solid state polymer plastic by irradiation with ultraviolet light (UV) or other forms of synergistic stimulation such as electron beams, visible or invisible light, reactive chemicals applied by ink jet or via a suitable mask. UV curable chemicals are currently used as ink for high speed printing, in processes of coating or paper and other materials, as adhesives, and in other specialty areas.

Lithography is the art of reproducing graphic objects, using various techniques. Modern examples include photographic reproduction, xerography, and microlithography, as is used in the production of microelectronics. Computer generated graphics displayed on a plotter or a cathode ray tube are also forms of lithography, where the image is a picture of a computer coded object.

Computer aided design (CAD) and computer aided manufacturing (CAM) are techniques that apply the abilities of computers to the processes of designing and manufacturing. A typical example of CAD is in the area of electronic printed circuit design, where a computer and plotter draw the design of a printed circuit board, given the design parameters as computer data input. A typical example of CAM is a numerically controlled milling machine, where a computer and a milling machine produce metal parts, given the proper programming instructions. Both CAD and CAM are important and are rapidly growing technologies.

A prime object of the present invention is to harness the principles of computer generated graphics, combined with UV curable plastic and the like, to simultaneously execute CAD and CAM, and to produce three-dimensional objects directly from computer instructions. This invention, referred to as stereolithography, can be used to sculpture models and prototypes in a design phase of product development, or as a manufacturing device, or even as an art form. The present invention enhances the developments in stereolithography set forth in U.S. Patent No. 4,575,330, issued March 11, 1986, to Charles in. Hull, one of the inventors herein.

Referring now more specifically to FIG. 2 of the drawings, the stereolithographic method is broadly outlined. Step 8 calls for generation of CAD or other data, typically in digital form, representing a three-dimensional object to be formed by the system. This CAD data usually defines surfaces in polygon format, triangles and normals perpendicular to the planes of these triangles, e.g., for slope indications, being presently preferred, and in a presently preferred embodiment of the invention conforms to the Programmer's Hierarchial Interactive Graphics System (PHIGS) now adapted as an ANSI standard. This standard is described, by way of example in the publication "Understanding PRIGS", published by Template, Megatek Corp., San Diego, California, which is hereby fully incorporated by reference as though set forth in full herein.

In Step 9, the PHIGS data or its equivalent is converted, in accordance with the invention, by a unique conversion system to a modified database for driving the stereolithography output system in forming three-dimensional objects. In this regard, information defining the object is specially processed to reduce stress, curl and distortion, and increase resolution, strength and accuracy of reproduction.

Step 10 in FIG. 2 calls for the generation of individual solid laminae representing cross-sections of a three-dimensional object to be formed. Step 11 combines the successively formed adjacent lamine to form the desired three-dimensional object which has been programmed into the system for selective curing.

Hence, the stereolithographic system of the present invention generates three-dimensional objects by creating a cross-sectional pattern of the object to be formed at a selected surface of a fluid medium, e.g., a UV curable liquid or the like, capable of altering its physical state in response to appropriate synergistic stimulation such as impinging radiation, electron beam or other particle bombardment, or applied chemicals (as by ink jet or spraying over a mask adjacent the fluid surface), successive adjacent laminae, representing corresponding successive adjacent cross-sections of the object, being automatically formed and integrated together to provide a step-wise laminar or thin layer buildup of the object, whereby a three-dimensional object is formed and drawn from a substantially planar or sheet-like surface of the fluid medium during the forming process.

The aforedescribed technique illustrated in FIG. 2 is more specifically outlined in the flowchart of FIG. 3, where again Step 8 calls for generation of CAD or other data, typically in digital form, representing a three-dimensional object to be formed by the system. Again, in Step 9, the PHIGS data is converted by a unique conversion system of a modified database for driving the stereolithography output system in forming three-dimensional objects. Step 12 calls for containing a fluid medium capable of solidification in response to prescribed reactive stimulation. Step 13 calls for application of that stimulation as a graphic pattern, in response to data output from the computer 4 in FIG. 1, at a designated fluid surface to form thin, solid, individual layers at that surface, each layer representing an adjacent cross-section of a three-dimensional object to be produced. In the practical application of the invention, each lamina will be a thin lamina, but thick enough to be adequately cohesive in forming the cross-section and adhering to the adjacent laminae defining other cross-sections of the object being formed.

Step 14 in FIG. 3 calls for superimposing successive adjacent layers or laminae on each other as they are formed, to the various layers that define the desired three-dimensional object. In the normal practice of the invention, as the fluid medium cures and solid material forms to define one lamina, that lamina is moved away from the working surface of the fluid medium and the next lamina is formed in the new liquid which replaces the previously formed lamina, so that each successive lamina is superimposed and integral with (by virtue of the natural adhesive properties of the cured fluid medium) all of the other cross-sectional laninae. Of course, as previously indicated, the present invention also deals with the problems posed in transitioning between vertical and horizontal.

The process of producing such cross-sectional laminae is repeated over and over again until the entire three-dimensional object has been formed. The object is then removed and the system is ready to produce another object which may be identical to the previous object or may be an entirely new object formed by changing the program controlling the stereolithographic system.

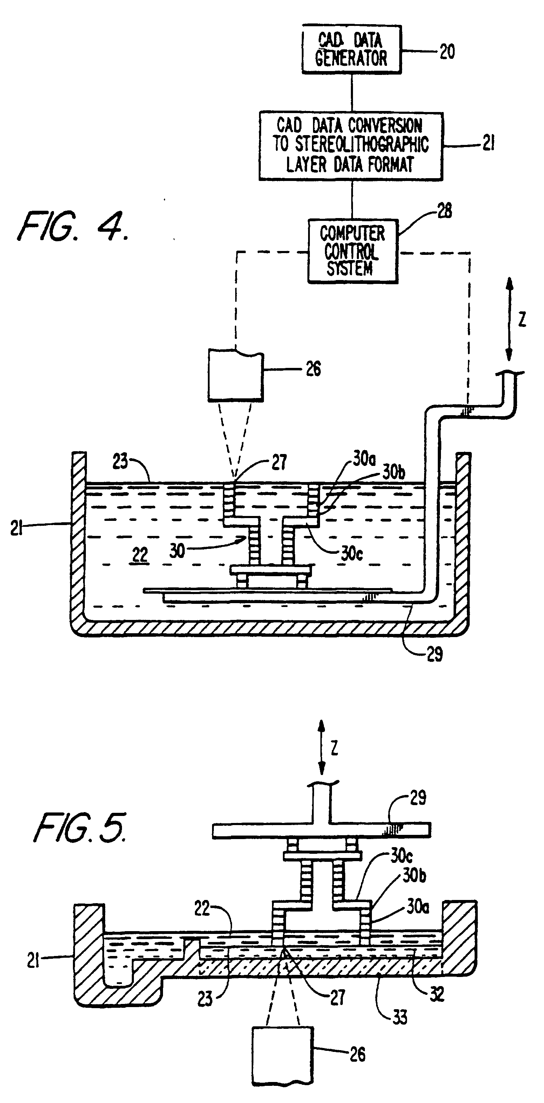

FIGS. 4-5 of the drawings illustrate various apparatus suitable for implementing the stereolithographic methods illustrated and described by the systems and flow charts of FIGS. 1-3.

As previously indicated, "stereolithography" is a method and apparatus for making solid objects by successively "printing" thin layers of a curable material, e.g., a curable material, one on top of the other. A programmable movable spot beam of light shining on a surface or layer of UV curable liquid is used to form a solid cross-section of the object at the surface of the liquid. The object is then moved, in a programmed manner, away from the liquid surface by the thickness of one layer and the next cross-section is then formed and adhered to the immediately preceding layer defining the object. This process is continued until the entire object is formed.

Essentially all types of object forms can be created with the technique of the present invention. Complex forms are more easily created by using the functions of a computer to help generate the programmed commands and to then send the program signals to the stereolithographic object forming subsystem.

The database of a CAD system can take several forms. One form, as previously indicated, consists of representing the surface of an object as a mesh of triangles (PHIGS). These triangles completely form the inner and outer surfaces of the object. This CAD representation also includes a unit length normal vector for each triangle. The normal points away from the solid which the triangle is bounding. This invention provides a means of processing such CAD data into the layer-by-layer vector data that is necessary for forming objects through stereolithography. More details about the different vector types are provided in S.N. 182,830, its CIP, S.N. 269,801, and its continuation, Lyon & Lyon Docket No. 186/195.

For stereolithography to successfully work, there must be good adhesion from one layer to the next. Hence, plastic from one layer must overlay plastic that was formed when the previous layer was built. In building models that are made of vertical segments, plastic that is formed on one layer will fall exactly on previously formed plastic from the preceding layer, and thereby provide good adhesion. As one starts to make a transition from vertical to horizontal features, using finite jumps in layer thickness, a point will eventually be reached where the plastic formed on one layer does not make contact with the plastic formed on the previous layer, and this causes severe adhesion problems. Horizontal surfaces themselves do not present adhesion problems because by being horizontal the whole section is built on one layer with side-to-side adhesion maintaining structural integrity. Therefore, means are provided for insuring adhesion between layers when making transitions from vertical to horizontal or horizontal to vertical sections, as well as providing a way to completely bound a surface, and ways to reduce or eliminate stress and strain in formed parts.

A presently preferred embodiment of a stereolithographic system is shown in elevational cross-section in FIG. 4. A container 21 is filled with a curable liquid 22 or the like, to provide a designated working surface 23. A programmable source of ultraviolet light 26 or the like produces a spot of ultraviolet light 27 in the plane of surface 23. The spot 27 is movable across the surface 23 by the motion of mirrors or other optical or mechanical elements (not shown in FIG. 4) used with the light source 26. The position of the spot 27 on surface 23 is controlled by a computer control system 28. As previously indicated, the system 28 may be under control of CAD data produced by a generator 20 in a CAD design system or the like and directed in PHIGS format or its equivalent to a computerized conversion system 25 where information defining the object is specially processed to reduce stress, curl and distortion, and increase resolution, strength and accuracy of reproduction.

A movable elevator platform 29 inside container 21 can be moved up and down selectively, the position of the platform being controlled by the system 28. As the device operates, it produces a three-dimensional object 30 by step-wise buildup of integrated laminae such as 30a, 30b, 30c.

The surface of the UV curable liquid 22 is maintained at a constant level in the container 11, and the spot of light 27, or other suitable form of reactive stimulation, of sufficient intensity to cure the liquid and convert it to a solid material is moved across the working surface 23 in a programmed manner. As the liquid 22 cures and solid material forms, the elevator platform 29 that was initially just below surface 23 is moved down from the surface in a programmed manner by any suitable actuator. In this way, the solid material that was initially formed is taken below surface 23 and new liquid 22 flows across the surface 23. A portion of this new liquid is, in turn, converted to solid material by the programmed light spot 27, and the new material adhesively connects to the material below it. This process is continued until the entire three-dimensional object 30 is formed. The object 30 is then removed from the container 21, and the apparatus is ready to produce another object. Another object can then be produced, or some new object can be made by changing the program in the computer 28.

The curable liquid 22, e.g., curable liquid, must have several important properties: (A) It must cure fast enough with the available UV light source to allow practical object formation times; (B) It must be adhesive, so that successive layers will adhere to each other; (C) Its viscosity must be low enough so that fresh liquid material will quickly flow across the surface when the elevator moves the object; (D) It should absorb UV so that the film formed will be reasonably thin; (E) It must be reasonably insoluble in that same solvent in the solid state, so that the object can be washed free of the UV cure liquid and partially cured liquid after the object has been formed; and (F) It should do as non-toxic and non-irritating as possible.

The cured material must also have desirable properties once it is in the solid state. These properties depend on the application involved, as in the conventional use of other plastic materials. Such parameters as color, texture, strength, electrical properties, flammability, and flexibility are among the properties to be considered. In addition, the cost of the material will be important in many cases.

The UV curable material used in the presently preferred embodiment of a working stereolithographic system (e.g., FIG. 3) is DeSoto SLR 800 stereolithography resin, made by DeSoto, Inc. of Des Plains, Illinois.

The light source 26 produces the spot 27 of light small enough to allow the desired object detail to be formed, and intense enough to cure the UV curable liquid being used quickly enough to be practical. The source 26 is arranged so it can be programmed to be turned off and on, and to move, such that the focused spot 27 moves across the surface 23 of the liquid 22. Thus, as the spot 27 moves, it cures the liquid 22 into a solid, and "draws" a solid pattern on the surface in much the same way a chart recorder or plotter uses a pen to draw a pattern on paper.

The light source 26 for the presently preferred embodiment of a stereolithography is typically a helium-cadmium ultraviolet laser such as the Model 4240-N HeCd Multimode Laser, made by Liconix of Sunnyvale, California.

In the system of FIG. 4, means may be provided to keep the surface 23 at a constant level and to replenish this material after an object has been removed, so that the focus spot 27 will remain sharply in focus on a fixed focus plane, thus insuring maximum resolution in forming a high layer along the working surface. In this regard, it is desired to shape the focal point to provide a region of high intensity right at the working surface 23, rapidly diverging to low intensity and thereby limiting the depth of the curing process to provide the thinnest appropriate cross-sectional laminae for the object being formed.

The elevator platform 29 is used to support and hold the object 30 being formed, and to move it up and down as required. Typically, after a layer is formed, the object 30 is moved beyond the level of the next layer to allow the liquid 22 to flow into the momentary void at surface 23 left where the solid was formed, and then it is moved back to the correct level for the next layer. The requirements for the elevator platform 29 are that it can be moved in a programmed fashion at appropriate speeds, with adequate precision, and that it is powerful enough to handle the weight of the object 30 being formed. In addition, a manual fine adjustment of the elevator platform position is useful during the set-up phase and when the object is being removed.

The elevator platform 29 can be mechanical, pneumatic, hydraulic, or electrical and may also be optical or electronic feedback to precisely control its position. The elevator platform 29 is typically fabricated of either glass or aluminum, but any material to which the cured plastic material will adhere is suitable.

A computer controlled pump (not shown) may be used to maintain a constant level of the liquid 22 at the working surface 23. Appropriate level detection systems and feedback networks, well known in the art, can be used to drive a fluid pump or a liquid displacement device, such as a solid rod (not shown) which is moved out of the fluid medium as the elevator platform is moved further into the fluid medium, to offset changes in fluid volume and maintain constant fluid level at the surface 23. Alternatively, the source 26 can be moved relative to the sensed level 23 and automatically maintain sharp focus at the working surface 23. All of these alternatives can be readily achieved by appropriate data operating in conjunction with the computer control system 28.

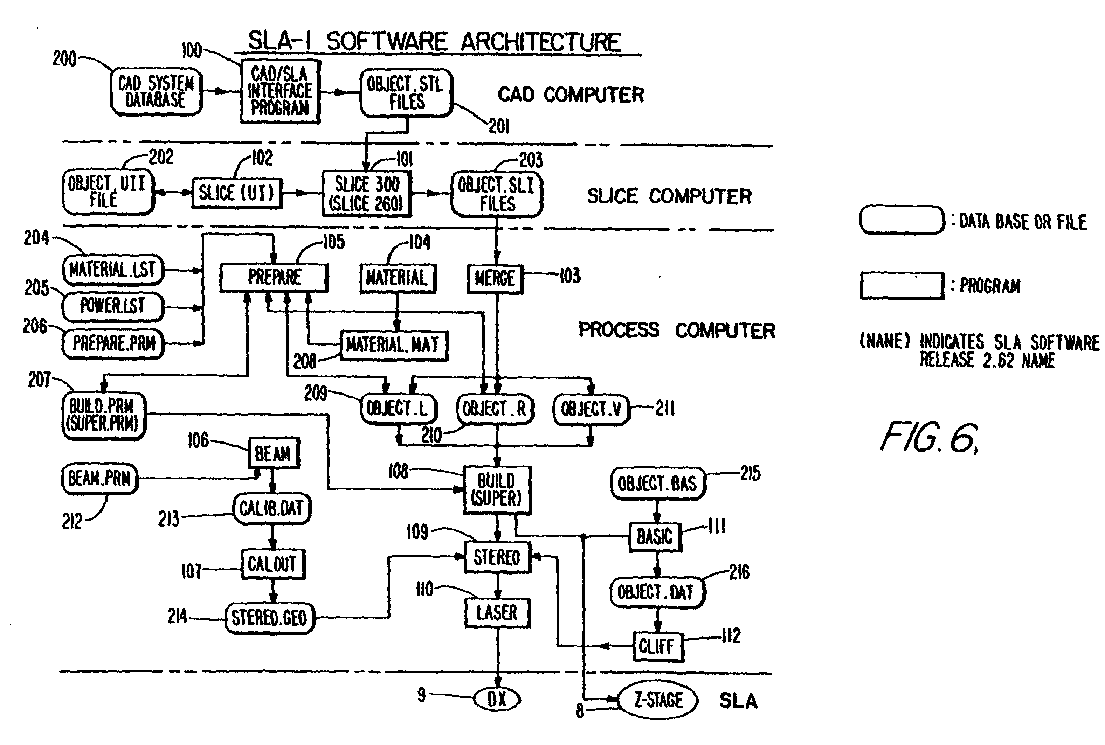

FIG. 6 of the drawings illustrates the overall software architecture of a stereolithography system in which the present invention may be practiced.

As an overview, the portion of our processing referred to as "SLICE" takes in the object that you want to build, together with any scaffolding or supports that are necessary to make it more buildable. These supports are typically generated by the user's CAD. The first thing SLICE does is to find the outlines of the object and its supports.

SLICE defines each microsection or layer one at a time under certain specified controlling styles. SLICE produces a boundary to the solid portion of the object. If, for instance, the object is hollow, there will be an outside surface and an inside one. This outline then is the primary information. The SLICE program then takes that outline or series of outlines and says, but if you build an outside skin and an inside skin they won't join to one another, you'll have liquid between them. It will collapse. So let us turn this into a real product, a real part by putting in crosshatching between the surfaces or solidifying everything in between or adding skins where it's so gentle a slope that one layer wouldn't join on top of the next, remembering past history or slope of the triangles (PHIGS) whichever way you look at it. SLICE does all those things and uses some lookup tables of the chemical characteristics of the photopolymer, how powerful the laser is, and related parameters to indicate how long to expose each of the output vectors used to operate the system. That output consists of identifiable groups. One group consists of the boundaries or outlines. Another group consists of cross-hatches. A third group consists of skins and there are subgroups of those, such as upward facing skins, and downward facing skins, which have to be treated slightly differently. These subgroups are all tracked differently because they may get slightly different treatment, in the process the output data is then appropriately managed to form the desired object and supports. These vector types are described in more detail in S.N. 182,830, its CIP S.N. 269,801, and its continuation, Lyon & Lyon Docket No. 186/195.

After the three-dimensional object 30 has been formed, the elevator platform 29 is raised and the object is removed from the platform for post processing.

In addition, there may be several containers 21 used in the practice of the invention, each container having a different type of curable material that can be automatically selected by the stereolithographic system. In this regard, the various materials might provide plastics of different colors, or have both insulating and conducting material available for the various layers of electronic products.

As will be apparent from FIG. 5 of the drawings, there is shown an alternate configuration of a stereolithography wherein the curable liquid 22 or the like floats on a heavier transparent liquid 32 which is non-miscible and non-wetting with the curable liquid 22. 3y way of example, ethylene glycol or heavy water are suitable for the intermediate liquid layer 32. In the system of FIG. 4, the three-dimensional object 30 is pulled up from the liquid 22, rather than down and further into the liquid medium, as shown in the system of FIG. 3.

The UV light source 26 in FIG. 5 focuses the spot 27 at the interface between the liquid 22 and the non-miscible intermediate liquid layer 32, the UV radiation passing through a suitable UV transparent window 33, of quartz or the like, supported at the bottom of the container 21. The curable liquid 22 is provided in a very thin layer over the non-miscible layer 32 and thereby has the advantage of limiting layer thickness directly rather than relying solely upon absorption and the like to limit the depth of curing since ideally an ultra-thin lamina is to be provided. Hence, the region of formation will be more sharply defined and some surfaces will be formed smoother with the system of FIG. 5 than with that of FIG. 4. In addition a smaller volume of curable liquid 22 is required, and the substitution of one curable material for another is easier.

A commercial stereolithography system will have additional components and subsystems besides those previously shown in connection with the schematically depicted systems of FIGS. 1-5. For example, the commercial system would also have a frame and housing, and a control panel. It should have means to shield the operator from excess and visible light, and it may also have means to allow viewing of the object 30 while it is being formed. Commercial units will provide safety means for controlling ozone and noxious fumes, as well as conventional high voltage safety protection and interlocks. Such commercial units will also have means to effectively shield the sensitive electronics from electronic noise sources.

Part supports are provided by the user during CAD design.

The following is an outline of the narrative description of the need for supports provided earlier in the application.

### The Need for Part Supports

A. To Separate Parts from Platform
   1. Easier to remove cured part
   2. Better control of thickness of first layer
   3. Holes in platform cause matching pattern on part
B To Improve Liquid Flow In and Around Part
   1. Liquid settles faster
   2. Minimizes dip time
   3. Part drains faster and better
C To Anchor Freely Floating Layer Borders
   1. For a sphere, below equator, layer border diameters increase rapidly
   2. Layer borders will drift until hatch vectors are drawn
      a. Air currents
      b Convection currents in liquid
   3. Outside supports not needed above equator, inside maybe

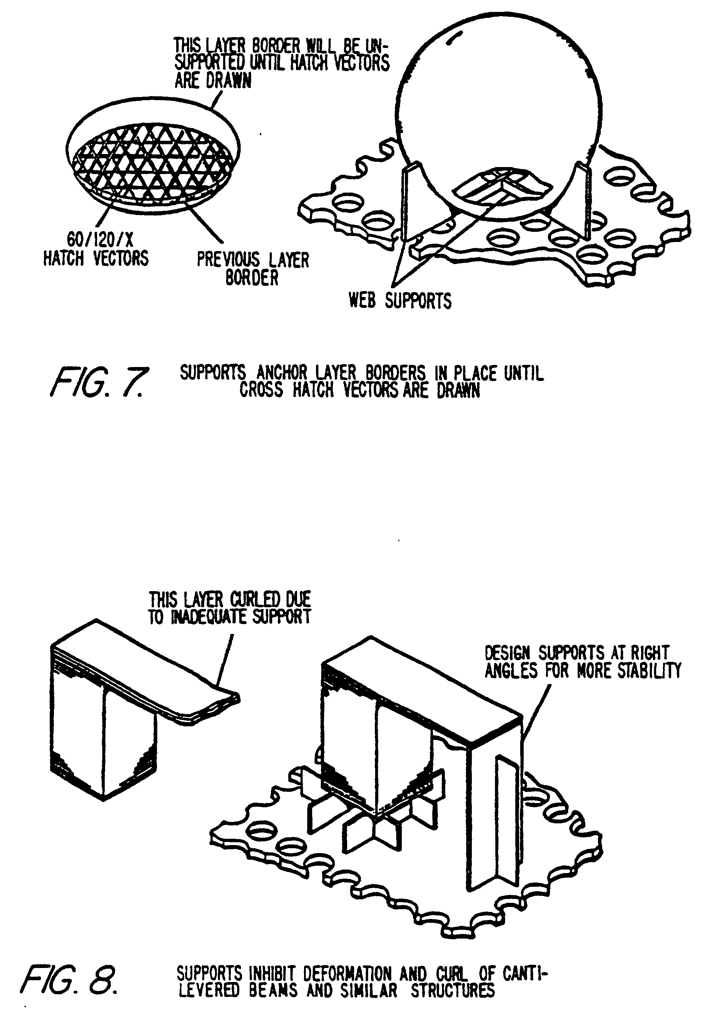

   FIG. 7 illustrates how supports anchor layer borders in place until cross-hatch vectors are drawn.
D. To Strengthen Otherwise Unsupported Layer Sections
   1. Prevents deformation
      a. During dipping
      b. Due to increasing weight of part
   2. Prevents curl
      a. Layer section cannot withstand stress
      b. Can use Smalleys or supports

   FIG. 8 illustrates how supports inhibit deformation and curl of cantilevered beams and similar structures.
E. To Anchor Unattached Layer Sections
   1. Such layer sections will drift during dipping
   2. Support is base on which part is built
   3. Support must exist one layer below first unconnected section.

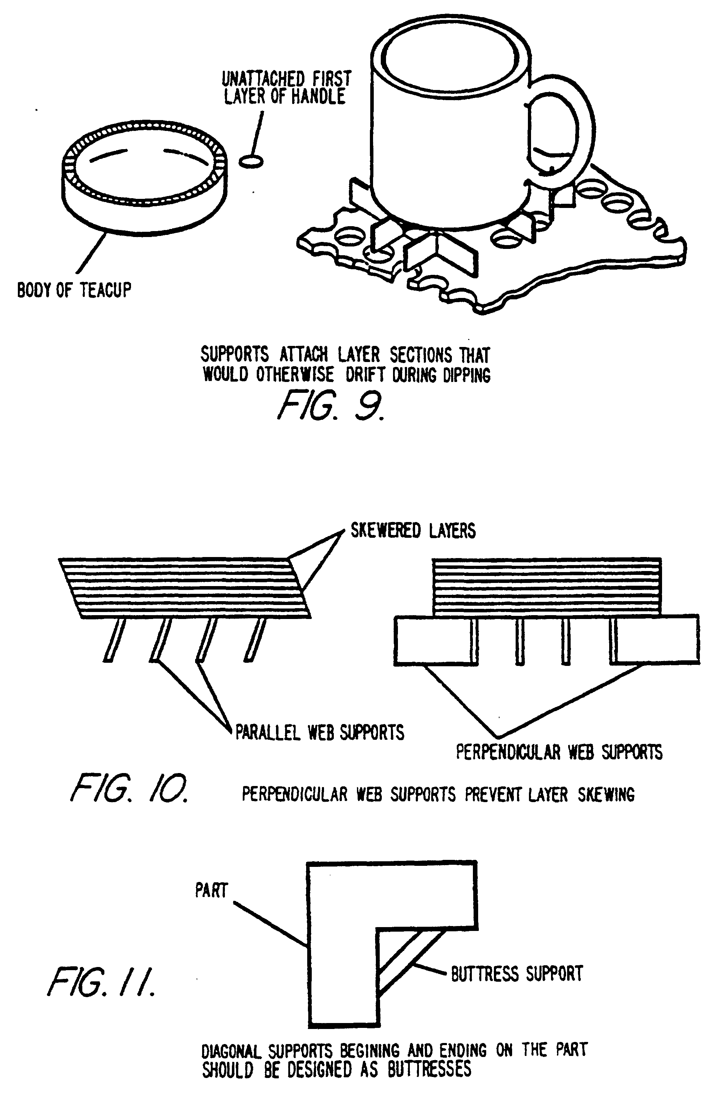

   FIG. 9 illustrates how supports attach layer sections that would otherwise drift during dipping.

The following is an outline of the narrative description of web supports, which is provided later on in the application.

### Web Supports

In a presently preferred embodiment of the invention, "web" supports are preferred.
A. Most Practical Shape
   1. Easy to remove
   2. Will not fall through platform
   3. Does not take long to draw
      a. Two back-to-back layer borders
      b. No cross-hatches necessary
      c. No skins necessary.
B. Can Make CAD Library of Commonly Used Support Styles.
   1. Use similar supports for many different parts
   2. Faster to modify existing supports than create new ones

Example A: Near the bottom of the solid sphere shown in Figure 7, the layer border vectors consist of circles whose diameters increase rapidly with each successive layer. Until the cross-hatch vectors are drawn, many of the layer borders would float freely on the surface of the liquid. Air currents or convection currents in the liquid could cause them to drift out of position.

Adding supports which extend to the equator of the sphere, as shown in FIG. 7, solves this problem. Note that above the equator, the layer borders are formed directly on the cross-hatch vectors of the previous layer, and as such are firmly anchored without the need for further support.

Example B: The first layer of the cantilevered beam shown in Figure 8 (or any unsupported layer border) may be permanently deformed by the static resistance of the liquid when the part is dipped. In addition, the layer could curl upward when the next layer is formed. Both of those problems are solved by adding supports.

Example C: The first layer of the teacup handle shown in Figure 9 would be completely unattached when formed and would drift when the part is dipped. The support provides a surface, anchored to the elevator platform or to the body of the teacup, on which the handle can be built.

### Designing Supports

The most practical type of support is the thin, vertical web shown in the previous illustrations. Web supports are easy to remove during post processing and, if they are designed properly, will not fall through the holes in the elevator platform. Other shapes could provide the necessary support, but would take longer to draw.

Generally, supports are designed together as a single CAD file separate from the part file. They are positioned relative to the solid model after the part is designed and oriented for Stereolithography. The object and support files are merged and drawn as a single file later in the stereolithography process. A library cf supports resident in the CAD is recommended, rather than designing unique supports for each application. In either case, supports should be designed and attached to the part in accordance with the following guidelines.

Placement: Supports should be located as needed to provide a rigid foundation on which the part may be built. Supports should also be added to anchor or strengthen other surfaces, as discussed in the preceding examples.

After the part is post-cured and the supports are removed, ridges will normally remain on the surface of the part. (The ridges can be cut and sanded or ground away.) Thus, if possible, avoid placing supports on surfaces that for aesthetic or functional reasons need to be smooth. Supports need not be attached to the elevator platform, but can instead be anchored to a strong section of the part.

Spacing: In general, supports should be spaced at sufficiently close intervals so that no appreciable sag or curl occurs; however, drawing too many supports will slow the part building process. Web supports should typically 0,25-2,03·10⁻² m be spaced (0.1 to 0.8 inch) apart.

Orientation: If all web supports for a part are aligned parallel to one another, as shown in Figure 10, the weight of the part could cause the webs to sag sideways while the part is being built. Subsequent layers would then be offset slightly (skewed) with respect to the previous layers. The addition of web supports more or less perpendicular to the parallel webs will prevent layer skewing.

Height: To inhibit bending or sagging and to minimize drawing time, web supports should be no taller than required; however, the part must be suspended at least 0,63·10⁻² m (0.25 inch) above the elevator platform to ensure optimum liquid draining and settling (relaxing). If a tall web is needed, a second web perpendicular to the first should be added for additional support. In cross-section, the combined support would look like a plus sign, as shown in Figure 10.

Length: To minimize drawing time, supports should be only as long as necessary. However, web supports built on the platform must be at least 1,65·10⁻² m (0.65 inch) long where they contact the platform or they may droop or fall through the holes. Diagonal supports beginning and ending on the part should be designed as buttresses, as shown in Figure 11, and should not extend into the corner of the part where they will be hard to remove.

Width: Web supports should be designed as slabs of 25-50·10⁻⁶ m (1-2 mil) CAD thickness. Since the width of the lines drawn with the laser is usually 250-500·10⁻⁶ m (10 to 20 mils), the actual support will be considerably thicker than the CAD design. Supports designed as single surfaces with no CAD volume will confuse the software which creates cross-hatching, and should be avoided.

If beam width compensation is used, the supports should be designed with the actual width desired, i.e., 250-500-10⁻⁶ m (10-20 mils), since the beam width compensation algorithm will compensate for the thickness of the lines drawn with the laser. Beam width compensation is described in more detail in S.N. 182,830, its CIP, S.N. 269,801, and its continuation, Lyon & Lyon Docket No. 186/195.

Attachment: To ensure that the part is securely attached to the supports, design the web supports to overlap the part vertically by two or three layer thicknesses (typically 1-1,5-10⁻³ m (40 to 60 mils)).

### Common Types of Supports

- Straight Webs: are very thin rectangles or fins, generally less than 5·10⁻⁵ m (0.002 inch) thick. Straight web supports must be defined by a volume, net single surfaces.
- Cross Webs: are made from two straight webs which intersect at right angles. Cross web supports are stronger than straight webs.
- Circular Webs: are hollow tubes strongly bonded to the object. Circular webs can support more weight than straight and cross web supports. However, they require more triangles, and thus use more memory.
- Triangular Webs: are composed of three straight webs to form a triangle. These supports may be used in conjunction with straight webs which intersect the vertices. Triangular web supports are stronger than all other types of web supports.

### Building Supports

As mentioned earlier, supports are designed together in a single CAD file separate from the part file. These stereolithography (.STL) files are the sliced, or cross-sectioned, before being merged into one file. The features of the slicing software (SLICE) and merging software (MERGE) applicable to supports are described below. More details about commercial embodiments of SLICE and MERGE are provided in S.N. 182,830, its CIP, S.N. 269,801, and its Lyon & Lyon Docket No. 186/195.

Slicing Support Files: SLICE has several options which are usually set to zero when slicing support files. Since web supports are thin, cross-hatching is unnecessary, so the X, Y and 60/120 hatch spacing values should be set to zero. For the same reason, supports do not need skins, so the X and Y skin fill values may also be zeroed. Minimum surface angle for scanned facets (MSA) and minimum hatch intersect angle (MIA) should be set to zero because web supports do not need near-flat skins and have no cross-hatching.

The SLICE scale and Z spacing values selected for the support file must be compatible with the values chosen for the part file; that is, the support SLICE thickness must be evenly divisible by or identical to the SLICE thickness of the part file (in the overlap region). Otherwise, it will be impossible to draw lines for the supports and the part in the same layer.

Selecting. The Step Period: In forming the walls of the web support 25·10⁻⁶ m ((one mil) apart), the layer border exposed while drawing the first wall will again be exposed while the second is drawn, because of the relatively broad laser line width. This effectively doubles the step period. For this reason, the step period obtained from the working curve may be divided by two before it is entered.

Editing The Layer Control File: The final operator action required to build supports is to use PREPARE menu options to increase the default step period value for the layer border vectors forming the first layer of the supports. Doing so increases the thickness (cure depth) of the layer. Normally, tripling the default support step period ensures adequate adhesion of the first layer of the supports to the platform.

Another method of creating web supports is by creating a box with internal cross-hatching below the part being cured. In this latter approach, the already implemented SLICE algorithms for generating hatch vectors could be used to generate the web supports. This approach avoids the necessity of designing web supports in the CAD/CAM system, as described above. The box could be created in a separate .STL file, placed into its own .SLI file, then merged with the .SLI file for the part after slicing. Specifically, a straight web could be created by hatching in the X or Y directions (not both). A crisscrossed web support could be implemented by hatching in the X and Y directions. A triangular web support could be implemented by hatching at 60/120 degrees and in either the X or the Y directions. In addition, the hatch spacing should be chosen to be 6,35-25,4·10⁻³ m (1/4" to 1") depending on the support needed.

An example of one embodiment of a commercial system, provided by 3D Systems, Inc. of Sylmar, California, embodying the present invention, is illustrated and described by the enclosed appendices, wherein Appendix A is a Users Manual and a Systems Manual describing the overall system for an early 3D Systems Model SLA-1 Beta Site Stereolithography System, including installation and operation, Appendix D is a Training Manual for the 3D Systems Model SLA-1 Stereolithography System, and Appendix I is a 3D Systems CAD/CAM Stereclithography Interface Specification for a suitable interface between CAD/CAM equipment and the Model SLA-1 Stereolithography System.

The stereolithographic method and apparatus has many advantages over currently used methods for producing plastic objects. The method avoids the need of producing tooling drawings and tooling. The designer can work directly with the computer and a stereolithographic device, and when he is satisfied with the design as displayed on the output screen of the computer, he can fabricate a part for direct examination, information defining the object being tailored to provide supports to reduce curl and distortion, and increase resolution, strength and accuracy of reproduction. If the design has to be modified, it can be easily done through the computer, and then another part can be made to verify that the change was correct. If the design calls for several parts with interacting design parameters, the method becomes even more useful because all of the part designs can be quickly changed and made again so that the total assembly can be made and examined, repeatedly if necessary.

After the design is complete, part production can begin immediately, so that the weeks and months between design and production are avoided. Ultimate production rates and parts costs should be similar to current injection molding costs for short run production, with even lower labor costs than these associated with injection molding. Injection molding is economical only when large numbers of identical parts are required. Stereolithography is particularly useful for short run production because the need for tooling is eliminated and production set-up time is minimal. Likewise, design changes and custom parts are easily provided using the technique. Because of the ease of making parts, stereolithography can allow plastic parts to be used in many places where metal or other material parts are now used. Moreover, it allows plastic models of objects to be quickly and economically provided, prior to the decision to make more expensive metal or other material parts.

The present invention satisfies a long existing need in the art for a CAD and CAM system capable of rapidly, reliably, accurately and economically designing and fabricating three-dimensional plastic parts and the like.

It will be apparent from the foregoing that, while particular forms of the invention have been illustrated and described, various modifications can be made without departing from the scope of the invention. Accordingly, it is not intended that the invention be limited, except as by the appended claims.

### 3.2 ORIENT & SUPPORT

### Orienting CAD Models

A CAD part must reside entirely in the positive X Y Z quadrant for StereoLithography. It should then be oriented to:
- minimize the distance between the part and the CAD origin.
- minimize the height of the support structure. The part should be at least 0.25 inch above the platform for efficient draining. However, supports that are too tall take longer to build and may distort as the weight of the part increases while it is being built.
- minimize the height of the object. This reduces the number of layers to be built, thereby reducing the run time.
- optimize part draining.
- minimize the number of slanted or sloping surfaces. These surfaces are constructed of overlapping layers so that the surface has a "stair-step" appearance, with the thickness of each layer being the height of the step.
- ensure that smooth or aesthetically important surfaces are either oriented vertically or upward-facing and horizontal. (Vertical and upward-facing horizontal surfaces are smoother than downward-facing surfaces.)
- minimize the volume of liquid entrapped as the part is built. Entrapped liquid slows the part building process by requiring more time for the liquid resin to settle and level to a uniform height after the part is dipped.
- Ensure that important circular cross-sections are drawn in the X-Y plane. Higher resolution can be achieved in the X-Y plane.
- Ensure that the part fits in the resin vat. If the part is too large, it may be sectioned, built in several runs, then reassembled during post processing.

The importance of each of these factors is determined by your objectives in making the part.

### Supports

StereoLithographic objects are built on supports rather than directly on the elevator platform. The main reasons for using supports are to:
- separate the object from the platform. This ensures that:
   -- they are easily separated during post processing.
   -- the first object layer is of uniform thickness, even if the platform is warped or improperly installed.
   -- resin can drain quickly through the platform. This reduces the time required to build the part, since the surface of the resin levels faster after the part is dipped. Additionally, excess resin drains faster from the completed part to reduce post processing time.
- anchor the part firmly to the platform or other part sections.
- prevent curling or damage during dipping.

### Common Types of Supports

- ***Straight Webs***: are very thin rectangles or fins, generally less than 0.002 inch thick. Straight web supports must be defined by a volume, not single surfaces.
- ***Cross Webs***: are made from two straight webs which intersect at right angles. Cross web supports are stronger than straight webs.
- ***Circular Webs***: are hollow tubes strongly bonded to the object. Circular webs can support more weight than straight and cross web supports. However, they require more triangles, and thus use more memory.
- ***Triangular Webs***: are composed of three straight webs to form a triangle. These supports may be used in conjunction with straight webs which intersect the vertices. Triangular web supports are stronger than all other types of web supports.

### Example 1

Near the bottom of the solid sphere, layer border vectors consist of circles whose diameters increase rapidly with each successive layer. Until other vectors are drawn, many of the layer borders would float freely on the surface of the liquid. Air currents or convection currents in the liquid could cause them to drift out of position.

Adding supports which extend to the equator of the sphere, as shown, would solve this problem. Note that above the equator the layer borders are formed directly on the crosshatch vectors of the previous layer, and as such are firmly anchored without the need for further support

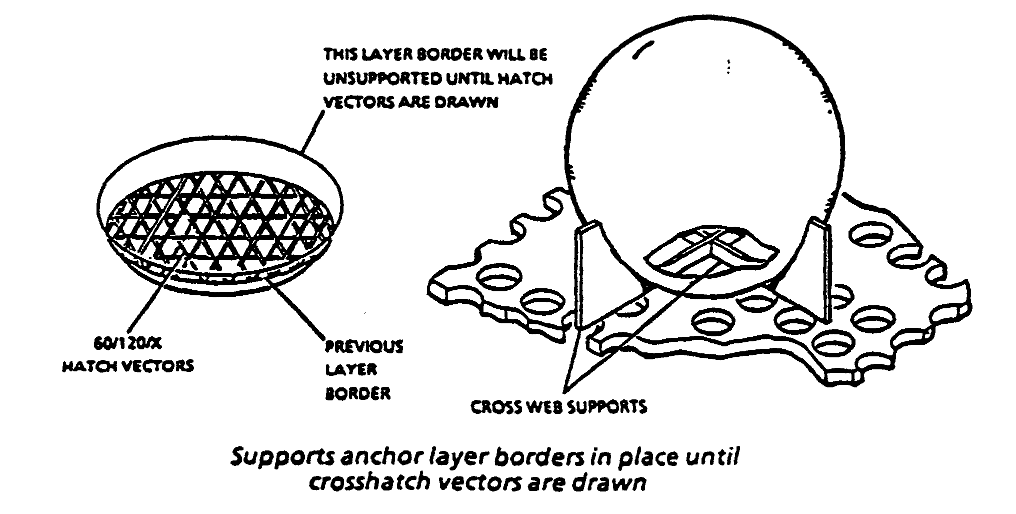

### Example 2

The first layer of the cantilevered beam may be permanently deformed by static resistance of the liquid when the part is dipped. In addition, the layer could curl upward when the next layer is formed. Both of these problems are solved by adding supports.

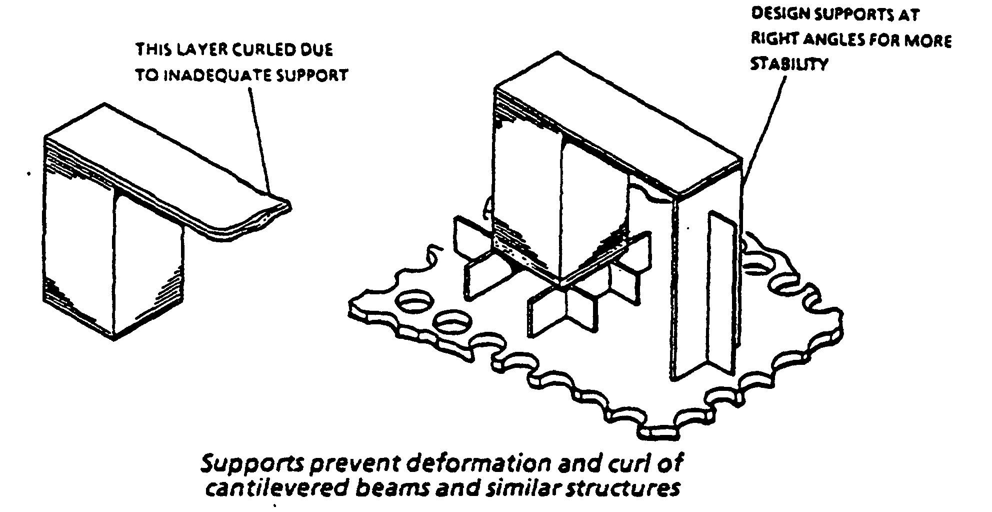

### Example 3

The first layer of the teacup handle would be completely unattached when formed and would drift when the part is.dipped. The support provides a surface, anchored to the elevator platform or to the body of the teacup, on which the handle can be built. 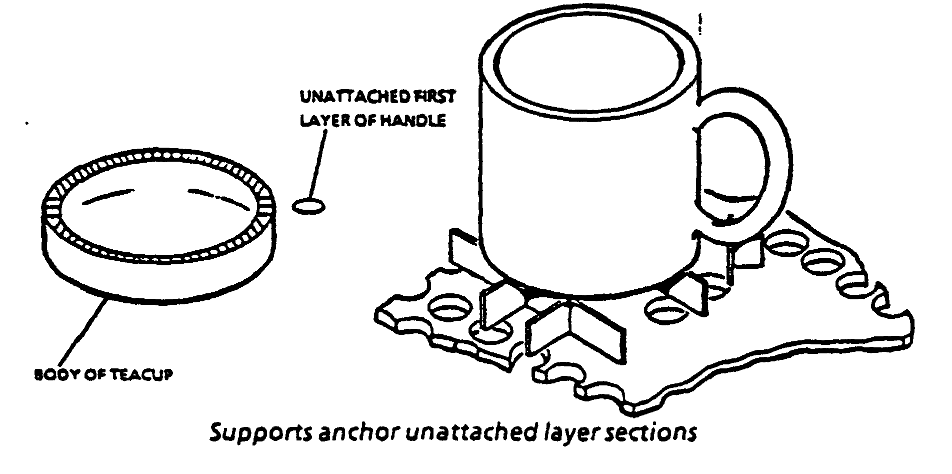
- ***Spacing***: Supports typically are spaced 0.1 to 0.8 inch apart. In general terms, space supports at sufficiently close intervals so that no appreciable sag or curl occurs; however, drawing too many supports will slow the part building process.
- ***Orientation***: Use cross web supports to prevent layer skewing. If straight web supports for a part are aligned parallel to one another, as shown below, the weight of the part could cause the webs to sag sideways while the part is being built. Subsequent layers would then be offset slightly (skewed) with respect to the previous layers.
- ***Height***: Hold parts at least 0.25 inch above the elevator platform to ensure optimum liquid draining and leveling. To inhibit bending or sagging and to minimize drawing time, supports should be no taller than required. If a tall support is needed, a cross, circular or triangular web should be used for additional strength.

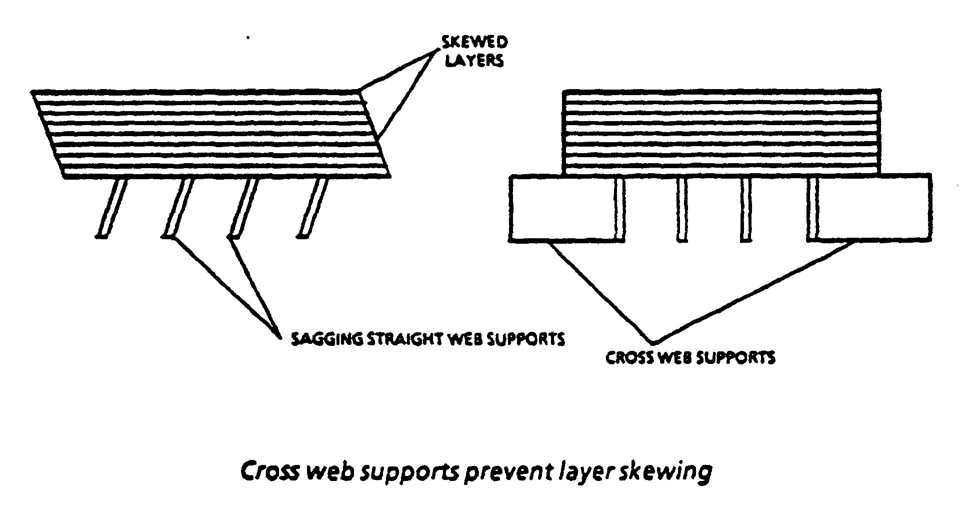

### Building Supports

### NOTES:

- Supports must be completely contained in positive CAD space.
- Bottom supports should overlap the bottom layers of the object by approximately 0.040 to 0.060 inch (typically 2 to 3 layers). This ensures a strong bond between the supports and object.
- Side supports should also overlap the object to provide a stronger support structure.

Generally, supports are designed together as a single CAD file separate from the object file. They are positioned relative to the object after it is designed and oriented for StereoLithography. (The object and support files are merged and drawn as a single file later in the StereoLithographic process.) A library of supports resident on the CAD system could reduce the need for designing unique supports for each object. In any case, supports should be designed and attached to the object in accordance with the following guidelines.
- ***Placement***: Supports should be located as needed to provide a rigid foundation on which the object can be built. This includes supporting corners and edges. Supports should also be added to anchor or strengthen other surfaces, as discussed in the preceding examples.
If possible, avoid placing supports on surfaces that for aesthetic or functional reasons need to be smooth. After the part is post-cured and the supports are removed, ridges will normally remain on the surface of the part. (The ridges can, however, be cut and sanded or ground away.) Supports can be attached to a strong section of the object, as well as to the elevator platform.
- ***Width***: Supports must be at least 0.65 inch wide where they contact the platform or they may droop or fall through the platform drain holes. However, to minimize drawing time, supports should be only as wide as necessary. Diagonal supports beginning and ending on the part should be designed as buttresses, as shown below, and should not extend into the corner of the part where they will be hard to remove. 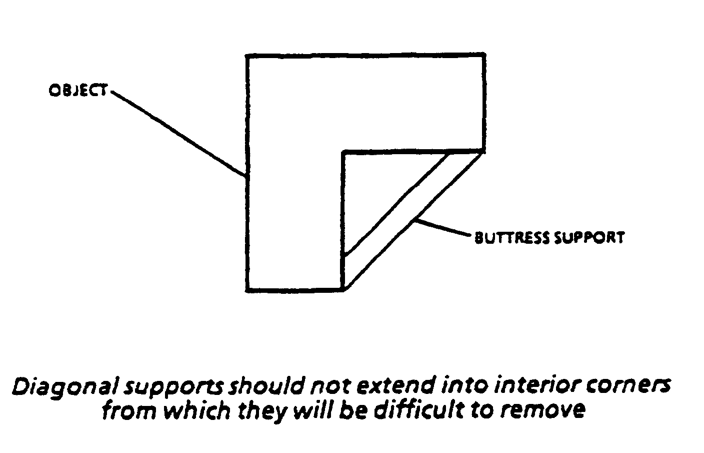
- ***Thickness***: Supports should be designed with minimum thickness (web supports should be 1 mil thick). Since the thickness of lines drawn with the laser is usually 10 to 20 mils, the actual support will be considerably thicker than the CAD design. Supports designed as single surfaces with no CAD volume are not allowed.
- ***Attachment***: To ensure that the object attaches securely to the supports, design supports to overlap the object vertically by 0.040 to 0.060 inch (typically 2 to 3 layers).

## Claims

1. A stereolithographic method of forming a three-dimensional object (30) comprising:
providing data (8) representing the three-dimensional object (30) to be formed;
providing data representing a support structure for use in forming the three-dimensional object; **characterized in that**
the method further comprises slicing the data representing the support structure to obtain cross-sectional support data representing the support structure; and
using the object data and the cross-sectional support data to form (11) the three-dimensional object (30) and support structure from a plurality of integrated cross-sections (30a, 30b, 30c).

2. A stereolithographic method of forming a three-dimensional object (30) comprising:
providing data (8) representing the three-dimensional object (30) to be formed;
defining a region (29) to be provided with a plurality of support structures;
deriving data representing the plurality of support structures for use in forming the three-dimensional object (30); **characterized in that**
the method further comprises merging the object data and support data together to produce build data; and
using the build data to form the three-dimensional object (30) and support structures from a plurality of integrated cross-sections (30a, 30b, 30c).

3. The method of claims 1 or 2, wherein said support structure is a web support, having a longitudinally-shaped structure, which support contacts a part of the region of the object (30) to be supported.

4. The method of claims 1 or 2, wherein said support structure includes a diagonal support extending to said surface to be supported.

5. The method of claims 1 to 4, wherein said support structure data comprise data for a first structure and a second structure, said second structure being a removable support structure.

6. The method of claims 1 to 5, wherein said support structure data comprise data for a first support structure and a second support structure, said first and second support structure being intersecting.

7. The method of claims 1 to 5, wherein said support structure data comprise data for a first support structure and a second support structure, said first and second support structure being spaced from each other.

8. The method of claims 1 to 7, wherein said three-dimensional object (30) is formed of a medium (22) solidifiable upon exposure to a prescribed stimulation.

9. The method of claim 8, wherein said medium (22) is a photopolymer.

10. The method of claim 8, wherein said prescribed stimulation is achieved either by electron beams, visible or invisible light, or reactive chemicals.

11. The method of claim 8, wherein said prescribed stimulation is ultraviolet radiaton (26).

12. The method of claims 8 to 11, wherein the width of the support structure is less than approximately two cure widths of the material.

13. The method of claim 12, wherein said support structure is specified to be formed upon exposure of said material to said prescribed stimulation in accordance with two adjacent lines.

14. The method of claims 1 to 13, further comprising associating object slicing options with the object data representing the three-dimensional object (30), and associating support structure slicing options with the support structure data.

15. The method of claims 1 to 13, further comprising associating object building options with the object data representing the three-dimensional object (30), and associating support structure building options with the support structure data.

16. A stereolithographic apparatus for forming a three-dimensional object (30), comprising:
means (2, 3) for providing data representing the three-dimensional object (30) to be formed;
means for providing data representing a support structure for use in forming the three-dimensional object (30); **characterized in that**
the apparatus further comprises
means (4) for slicing the data representing the support structure to obtain cross-sectional support data representing the support structure; and
means (5) for using the object data and the cross-sectional support data to form the three-dimensional object (30) and support structure from a plurality of integrated cross-sections (30a, 30b, 30c).

17. A stereolithographic apparatus for forming a three-dimensional object (30) comprising:
means (2, 3) for providing data representing the three-dimensional object (30) to be formed;
means for defining a region to be provided with a plurality of support structures;
a computer (4) programmed to derive data representing the plurality of support structures for use in forming the three-dimensional object (30); **characterized in that**
the apparatus further comprises means for merging the object data and support data together to produce build data; and
means for using the build data to form the three-dimensional object (30) and support structures from a plurality of integrated cross-sections (30a, 30b, 30c).

18. The apparatus of claims 16 or 17, wherein said support structure is a web support, having a longitudinally-shaped structure, which support contacts a part of the region of the object (30) to be supported

19. The apparatus of claims 16 or 17, wherein said support structure includes a diagonal support extending to said surface to be supported.

20. The apparatus of claims 16 to 19, wherein said support structure data comprise data for a first structure and a second structure, said second structure being a removable support structure.

21. The apparatus of claims 16 to 20, wherein said support structure data comprise data for a first support structure and a second support structure, said first and second support structure being intersecting.

22. The apparatus of claims 16 to 21, wherein said support structure data comprise data for a first support structure and a second support structure, said first and second support structure being spaced from each other.

23. The apparatus of claims 16 to 22, wherein said three-dimensional object (30) is formed of a medium (22) solidifiable upon exposure to a prescribed stimulation.

24. The apparatus of claim 23, wherein said medium (22) is a photopolymer.

25. The apparatus of claim 23, wherein said prescribed stimulation is achieved either by electron beams, visible or invisible light, or reactive chemicals.

26. The apparatus of claim 23, wherein said prescribed stimulation is ultraviolet radiaton (26).

27. The apparatus of claims 23 to 26, wherein the width of the support structure is less than approximately two cure widths of the material.

28. The apparatus of claim 27, wherein said support structure is specified to be formed upon exposure of said material to said prescribed stimulation in accordance with two adjacent lines.

29. The apparatus of claims 16 to 28, further comprising means for associating object slicing options with the object data representing the three-dimensional object (30), and means for associating support structure slicing options with the support structure data.

30. The apparatus of claims 16 to 29, further comprising means for associating object building options with the object data representing the three-dimensional object (30), and means for associating support structure building options with the support structure data.

## Patentansprüche

1. Ein stereolithographisches Verfahren zur Bildung eines dreidimensionalen Objektes (30), aufweisend:
Bereitstellen von Daten (8), die das zu bildende dreidimensionale Objekt (30) repräsentieren,
Bereitstellen von Daten, die eine Stützstruktur zur Verwendung bei der Bildung des dreidimensionalen Objektes repräsentieren, **dadurch gekennzeichnet, daß**
das Verfahren weiter aufweist das in Scheiben Schneiden der Daten, die die Stützstruktur repräsentieren, um Querschnitts-Unterstützungsdaten zu erhalten, die die Stützstruktur repräsentieren, und
Verwendung der Objektdaten und der Querschnitts-Unterstützungsdaten zum Bilden (11) des dreidimensionalen Objektes (30) und der Stützstruktur von einer Vielzahl integrierter Querschnitte (30a, 30b, 30c).

2. Ein stereolithographisches Verfahren zur Bildung eines dreidimensionalen Objektes (30), aufweisend:
Bereitstellen von Daten (8), die das zu bildende dreidimensionale Objekt (30) repräsentieren,
Definieren einer bereitzustellenden Region (29) mit einer Vielzahl von Stützstrukturen;
Ableiten von Daten, die die Vielzahl von Stützstrukturen zur Verwendung bei der Bildung des dreidimensionalen Objektes (30) repräsentieren, **dadurch gekennzeichnet, daß**
das Verfahren weiter aufweist das Vereinen der Objektdaten und der Unterstützungsdaten, um Aufbaudaten zu produzieren, und
Verwendung der Aufbaudaten zur Bildung des dreidimensionalen Objektes (30) und der Stützstrukturen von einer Vielzahl von integrierten Querschnitten (30a, 30b, 30c).

3. Das Verfahren gemäß Anspruch 1 oder 2, wobei die Stützstruktur eine rippenartige Stütze ist, die eine länglich geformte Struktur aufweist, wobei die Stütze einen Teil der Region des zu stützenden Objektes (30) kontaktiert.

4. Das Verfahren gemäß der Ansprüche 1 oder 2, wobei die Stützstruktur eine diagonale Stütze umfaßt, die sich zu der zu unterstützenden Oberfläche erstreckt.

5. Das Verfahren gemäß der Ansprüche 1 bis 4, wobei die Stützstrukturdaten Daten für eine erste Struktur und eine zweite Struktur umfassen, wobei die zweite Struktur eine entfernbare Stützstruktur ist.

6. Das Verfahren gemäß der Ansprüche 1 bis 5, wobei die Stützstrukturdaten Daten für eine erste Stützstruktur und eine zweite Stützstruktur umfassen, wobei sich die erste und die zweite Stützstruktur kreuzen.

7. Das Verfahren gemäß der Ansprüche 1 bis 5, wobei die Stützstrukturdaten Daten für eine erste Stützstruktur und eine zweite Stützstruktur umfassen, wobei die erste und die zweite Stützstruktur voneinander beabstandet sind.

8. Das Verfahren gemäß der Ansprüche 1 bis 7, wobei das dreidimensionale Objekt (30) aus einem Medium (22) geformt wird, das zur Verfestigung im Stande ist, wenn es einer vorgeschriebenen Stimulierung ausgesetzt wird.

9. Das Verfahren gemäß Anspruch 8, wobei das Medium (22) ein Photopolymer ist.

10. Das Verfahren gemäß Anspruch 8, wobei die vorgeschriebene Stimulierung entweder durch einen Elektronenstrahl, sichtbares oder unsichtbares Licht oder durch reaktive Chemikalien erzielt wird.

11. Das Verfahren gemäß Anspruch 8, wobei die vorgeschriebene Stimulierung ultraviolette Strahlung (26) ist.

12. Das Verfahren gemäß der Ansprüche 8 bis 11, wobei die Breite der Stützstruktur geringer ist als ungefähr zwei Aushärtbreiten des Materials.

13. Das Verfahren gemäß Anspruch 12, wobei die Stützstruktur spezifiziert ist, daß sie über das Aussetzen des Materials der vorgeschriebenen Stimulierung in Übereinstimmung mit zwei angrenzenden Linien geformt wird.

14. Das Verfahren gemäß den Ansprüchen 1 bis 13, weiter aufweisend das Zuordnen der Optionen zum in Scheiben Schneiden des Objektes zu den Objektdaten, die das dreidimensionale Objekt (30) repräsentieren, und Zuordnen der Optionen zum in Scheiben Schneiden der Stützstruktur zu den Stützstrukturdaten.

15. Das Verfahren gemäß den Ansprüchen 1 bis 13, weiter aufweisend das Zuordnen der Optionen zur Objektbildung zu den Objektdaten, die das dreidimensionale Objekt (30) repräsentieren, und das Zuordnen der Optionen zur Bildung der Stützstruktur zu den Stützstrukturdaten.

16. Eine stereolithographische Vorrichtung zur Bildung eines dreidimensionalen Objektes (30), aufweisend:
Mittel (2, 3) zum Bereitstellen von Daten, die ein zu bildendes dreidimensionales Objekt (30) repräsentieren;
Mittel zur Bereitstellung von Daten, die eine Stützstruktur zur Verwendung bei der Bildung des dreidimensionalen Objektes (30) repräsentieren, **dadurch gekennzeichnet, daß**
die Vorrichtung weiter aufweist:
Mittel (4) zum in Scheiben Schneiden der Daten, die die Stützstruktur repräsentieren, um Querschnittsunterstützungsdaten zu erhalten, die die Stützstruktur repräsentieren, und
Mittel (5) zur Verwendung der Objektdaten und der Querschnittsunterstützungsdaten zum Bilden des dreidimensionalen Objektes (30) und der Stützstruktur aus einer Vielzahl von integrierten Querschnitten (30a, 30b, 30c).

17. Eine stereolithographische Vorrichtung zur Bildung eines dreidimensionalen Objektes (30), aufweisend:
Mittel (2, 3) zum Bereitstellen von Daten, die ein zu bildendes dreidimensionales Objekt (30) repräsentieren;
Mittel zum Definieren einer bereitzustellenden Region mit einer Vielzahl von Stützstrukturen;
ein Computer (4), der programmiert ist, um Daten abzuleiten, die die Vielzahl von Stützstrukturen zur Verwendung bei der Bildung des dreidimensionalen Objektes (30) repräsentieren, **dadurch gekennzeichnet, daß**
die Vorrichtung weiter Mittel aufweist zum Vereinen der Objektdaten und der Unterstützungsdaten, um Aufbaudaten zu produzieren; und
Mittel zur Verwendung der Aufbaudaten, um ein dreidimensionales Objekt (30) und Stützstrukturen aus einer Vielzahl von integrierten Querschnitten (30a, 30b, 30c) zu bilden.

18. Die Vorrichtung gemäß der Ansprüche 16 oder 17, wobei die Stützstruktur eine rippenartige Stütze ist, die eine länglich geformte Struktur aufweist, wobei die Stütze einen Teil der Region des zu stützenden Objektes (30) kontaktiert.

19. Die Vorrichtung gemäß der Ansprüche 16 oder 17, wobei die Stützstruktur eine Diagonalstütze aufweist, die sich zu der zu stützenden Oberfläche erstreckt.

20. Die Vorrichtung gemäß der Ansprüche 16 bis 19, wobei die Stützstrukturdaten Daten für eine erste Struktur und eine zweite Struktur aufweisen, wobei die zweite Struktur eine entfernbare Stützstruktur ist.

21. Die Vorrichtung gemäß der Ansprüche 16 bis 20, wobei die Stützstrukturdaten Daten für eine erste Stützstruktur und eine zweite Stützstruktur aufweisen, wobei sich die erste und die zweite Stützstruktur kreuzen.

22. Die Vorrichtung gemäß der Ansprüche 16 bis 21, wobei die Stützstrukturdaten Daten für eine erste Stützstruktur und eine zweite Stützstruktur aufweisen, wobei die erste und die zweite Stützstruktur voneinander beabstandet sind.

23. Die Vorrichtung gemäß der Ansprüche 16 bis 22, wobei das dreidimensionale Objekt (30) aus einem Medium (22) geformt wird, das zur Verfestigung im Stande ist, wenn es einer vorgeschriebenen Stimulierung ausgesetzt wird.

24. Die Vorrichtung gemäß Anspruch 23, wobei das Medium (22) ein Photopolymer ist.

25. Die Vorrichtung gemäß Anspruch 23, wobei die vorgeschriebene Stimulierung entweder durch einen Elektronenstrahl, durch sichtbares oder unsichtbares Licht oder durch reaktive Chemikalien erzielt wird.

26. Die Vorrichtung gemäß Anspruch 23, wobei die vorgeschriebene Stimulierung ultraviolette Strahlung (26) ist.

27. Die Vorrichtung gemäß der Ansprüche 23 bis 26, wobei die Breite der Stützstruktur geringer als ungefähr zwei Aushärtbreiten des Materials ist.

28. Die Vorrichtung gemäß Anspruch 27, wobei die Stützstruktur spezifiziert ist, um über das Aussetzen des Materials der vorgeschriebenen Stimulierung in Übereinstimmung mit zwei angrenzenden Linien geformt zu werden.

29. Die Vorrichtung gemäß der Ansprüche 16 bis 28, weiter aufweisend Mittel zur Zuordnung von Optionen zum in Scheiben Schneiden des Objektes zu den Objektdaten, die das dreidimensionale Objekt (30) repräsentieren, und Mittel zum Zuordnen von Optionen zum in Scheiben Schneiden der Stützstruktur zu Stützstrukturdaten.

30. Die Vorrichtung gemäß den Ansprüchen 16 bis 29, weiter aufweisend Mittel zum Zuordnen von Optionen zur Objektbildung zu den Objektdaten, die das dreidimensionale Objekt (30) repräsentieren, und Mittel zum Zuordnen von Optionen zum Bilden von Stützstrukturen zu den Stützstrukturdaten.

## Revendications

1. Procédé stéréolithographique de formation d'un objet tridimensionnel (30), comprenant :
la fourniture de données (8) représentant l'objet tridimensionnel (30) à former ;
la fourniture de données représentant une structure de support pour utilisation dans la formation de l'objet tridimensionnel ; **caractérisé en ce que**
le procédé comprend en outre une mise en tranches des données représentant la structure de support pour obtenir des données de support en coupe transversale représentant la structure de support ; et
l'utilisation des données d'objet et des données de support en coupe transversale pour former (11) l'objet tridimensionnel (30) et une structure de support à partir d'une pluralité de sections transversales intégrées (30a, 30b, 30c).

2. Procédé stéréolithographique de formation d'un objet tridimensionnel (30) comprenant :
la fourniture de données (8) représentant l'objet tridimensionnel (30) à former ;
la définition d'une région (29) à munir d'une pluralité de structures de support ;
la dérivation de données représentant la pluralité de structures de support pour utilisation dans la formation de l'objet tridimensionnel (30) ; **caractérisé en ce que**
le procédé comprend en outre la fusion, les unes avec les autres, des données d'objet et des données de support pour produire des données de constitution ; et
l'utilisation des données de constitution pour former l'objet tridimensionnel (30) et des structures de support à partir d'une pluralité de sections transversales intégrées (30a, 30b, 30c).

3. Procédé selon les revendications 1 ou 2, dans lequel ladite structure de support est un support en bande, ayant une structure formée longitudinalement, lequel support contacte une partie de la région de l'objet (30) à supporter.

4. Procédé selon les revendications 1 ou 2, dans lequel ladite structure de support comprend un support diagonal s'étendant vers ladite surface à supporter.

5. Procédé selon les revendications 1 à 4, dans lequel lesdites données de structures de support comprennent des données d'une première structure et d'une seconde structure, ladite seconde structure étant une structure de support amovible.

6. Procédé selon les revendications 1 à 5, dans lequel lesdites données de structures de support comprennent des données d'une première structure de support et d'une seconde structure de support, lesdites première et seconde structures de support se coupant.

7. Procédé selon les revendications 1 à 5, dans lequel lesdites données de structures de support comprennent des données d'une première structure de support et d'une seconde structure de support, lesdites première et seconde structures de support étant espacées l'une de l'autre.

8. Procédé selon les revendications 1 à 7, dans lequel ledit objet tridimensionnel (30) est formé d'un milieu (22) qui peut solidifier lors d'une exposition à une stimulation prescrite.

9. Procédé selon la revendication 8, dans lequel ledit milieu (22) est un photopolymère.

10. Procédé selon la revendication 8, dans lequel ladite stimulation prescrite est obtenue soit par des faisceaux d'électrons, de la lumière visible ou invisible, soit par des agents chimiques réactifs.

11. Procédé selon la revendication 8, dans lequel ladite stimulation prescrite est un rayonnement ultraviolet (26).

12. Procédé selon les revendications 8 à 11, dans lequel la largeur de la structure de support est inférieure à environ deux largeurs polymérisées de la matière.

13. Procédé selon la revendication 12, dans lequel on spécifie que ladite structure de support se forme lors de l'exposition de ladite matière à ladite stimulation prescrite en fonction de deux lignes adjacentes.

14. Procédé selon les revendications 1 à 13, comprenant en outre l'association d'options de mise en tranches d'objet avec les données d'objet représentant l'objet tridimensionnel (30), et l'association d'options de mise en tranches de structures de support avec les données de structures de support.

15. Procédé selon les revendications 1 à 13, comprenant en outre l'association d'options de constitution d'objet avec les données d'objet représentant l'objet tridimensionnel (30), et l'association d'options de constitution de structures de support avec les données de structures de support.

16. Dispositif stéréolithographique de formation d'un objet tridimensionnel (30), comprenant :
des moyens (2, 3) destinés à fournir des données représentant l'objet tridimensionnel (30) à former ;
un moyen destiné à fournir des données représentant une structure de support pour utilisation dans la formation de l'objet tridimensionnel (30) ; **caractérisé en ce que**
l'appareil comprend en outre
un moyen (4) destiné à mettre en tranches les données représentant la structure de support pour obtenir des données de support en coupe transversale représentant la structure de support ; et
un moyen (5) pour utilisation des données d'objet et des données de support en coupe transversale pour former l'objet tridimensionnel (30) et la structure de support à partir d'une pluralité de sections transversales intégrées (30a, 30b, 30c).

17. Dispositif stéréolithographique de formation d'un objet tridimensionnel (30), comprenant :
des moyens (2, 3) destinés à fournir des données représentant l'objet tridimensionnel (30) à former ;
un moyen de définition d'une région à munir d'une pluralité de structures de support ;
un ordinateur (4) programmé pour dériver des données représentant la pluralité de structures de support pour utilisation dans la formation de l'objet tridimensionnel (30) ; **caractérisé en ce que**
le dispositif comprend en outre un moyen pour fusionner, les unes avec les autres, les données d'objet et les données de support pour produire des données de constitution ; et
un moyen destiné à utiliser les données de constitution pour former l'objet tridimensionnel (30) et des structures de support à partir d'une pluralité de sections transversales intégrées (30a, 30b, 30c).

18. Dispositif selon les revendications 16 ou 17, dans lequel ladite structure de support est un support en bande, ayant une structure formée longitudinalement, lequel support contacte une partie de la région de l'objet (30) à supporter.

19. Dispositif selon les revendications 16 ou 17, dans lequel ladite structure de support comprend un support diagonal s'étendant vers ladite surface à supporter.

20. Dispositif selon les revendications 16 à 19, dans lequel lesdites données de structures de support comprennent des données d'une première structure et d'une seconde structure, ladite seconde structure étant une structure de support amovible.

21. Dispositif selon les revendications 16 à 20, dans lequel lesdites données de structurés de support comprennent des données d'une première structure de support et d'une seconde structure de support, lesdites première et seconde structures de support se coupant.

22. Dispositif selon les revendications 16 à 21, dans lequel lesdites données de structures de support comprennent des données d'une première structure de support et d'une seconde structure de support, lesdites première et seconde structures de support étant espacées l'une de l'autre.

23. Dispositif selon les revendications 16 à 22, dans lequel ledit objet tridimensionnel (30) est formé d'un milieu (22) pouvant solidifier lors d'une exposition à une stimulation prescrite.

24. Dispositif selon la revendication 23, dans lequel ledit milieu (22) est un photopolymère.

25. Dispositif selon la revendication 23, dans lequel ladite stimulation prescrite est obtenue soit par des faisceaux d'électrons, de la lumière visible ou invisible, soit par des agents chimiques réactifs.

26. Dispositif selon la revendication 23, dans lequel ladite stimulation prescrite est un rayonnement ultraviolet (26).

27. Dispositif selon les revendications 23 à 26, dans lequel la largeur de la structure de support est inférieure à environ deux largeurs polymérisées de la matière.

28. Dispositif selon la revendication 27, dans lequel on spécifié que ladite structure de support se forme lors de l'exposition de ladite matière à ladite stimulation prescrite en fonction de deux lignes adjacentes.

29. Dispositif selon les revendications 16 à 28, comprenant en outre un moyen destiné à associer des options de mise en tranches d'objet avec les données d'objet représentant l'objet tridimensionnel (30), et un moyen destiné à associer des options de mise en tranches de structures de support avec les données de structures de support.

30. Dispositif selon les revendications 16 à 29, comprenant en outre un moyen destiné à associer des options de constitution d'objet avec les données d'objet représentant l'objet tridimensionnel (30), et un moyen destiné à associer des options de constitution de structures de support avec les données de structures de support.
